Europäisches Patentamt

European Patent Office

Office européen des brevets

(11) Veröffentlichungsnummer: **0 320 724**
**A2**

## EUROPÄISCHE PATENTANMELDUNG

(21) Anmeldenummer: **88120204.8**

(22) Anmeldetag: **03.12.88**

(51) Int. Cl.⁴: **C23C 16/48 , C23C 16/44 , C23C 16/50 , C23C 16/52 , C23C 16/54**

(30) Priorität: **09.12.87 DE 3741672**

(43) Veröffentlichungstag der Anmeldung:
**21.06.89 Patentblatt 89/25**

(84) Benannte Vertragsstaaten:
**CH DE FR LI NL**

(71) Anmelder: **Asea Brown Boveri**
**Aktiengesellschaft**
**Kallstadter Strasse 1**
**D-6800 Mannheim 31(DE)**

(72) Erfinder: **Esrom, Hilmar, Dr.**
**Fritz-Frey-Strasse 11**
**D-6900 Heidelberg(DE)**
Erfinder: **Schmaderer, Franz**
**Scipiostrasse 25**
**D-6831 Plankstadt(DE)**
Erfinder: **Wahl, Georg, Dr.**
**Franz-Liszt-Strasse 9**
**D-6904 Eppelheim(DE)**
Erfinder: **Jahnke, Bernd, Dr.**
**Gottlob-Kamm-Strasse 11**
**D-6903 Neckargemünd(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) **Verfahren und Anordnung zur Oberflächenbehandlung von Substraten.**

(57) Ein CVD-Verfahren zur Behandlung, insbesondere zur Einzelbeschichtung von Substraten, besonders für Halbleiterbauelemente, soll hinsichtlich der erforderlichen Bearbeitungszeit und der Gleichmäßigkeit des erzielten Ergebnisses verbessert werden.

Es wird vorgeschlagen, das benutzte Gasgemisch (5) zunächst in einer Kammer (10) aufzustauen und dann als Gasstrom (12) über eine Düse (11) zum Substrat (1) zu führen und den CVD-Prozeß mit Hilfe eines Laserstrahls zu aktivieren. Mehrere zusätzliche Maßnahmen zur weiteren Aktivierung des Prozesses sowie zur Überwachung und Regelung eines automatisierten Prozesses sind als Ausgestaltungen möglich.

Anwendung kann in der Halbleitertechnik zur Metallisierung von Substraten oder zur Passivierung von pn-Übergängen erfolgen. Außerdem kann nach diesem Verfahren eine strukturierung von Substratoverflächen durchgeführt werden.

Fig 2

## Verfahren und Anordnung zur Oberflächenbehandlung von Substraten

Die Erfindung bezieht sich auf ein Verfahren zur Oberflächenbehandlung von Substraten, insbesondere zum Beschichten durch Abscheidung eines Materials aus der Gasphase (CVD-Verfahren) gemäß dem Oberbegriff des Anspruchs 1 und auf eine Anordnung zur Durchführung des Verfahrens.

Solche Verfahren und Anordnungen werden z.B. in der Fertigung von Halbleiterbauelementen benötigt, u.a. zur Herstellung von Metallisierungen auf einer Substratoberfläche oder zur Passivierung von pn-Übergängen, die z.B. in geätzten Gräben an die Oberfläche treten. Für solche Beschichtungsprozesse sind CVD-(Chemical Vapour Deposition)-Anlagen geeignet, womit die gewünschten Schichten durch Abscheidung aus der Gasphase erzeugt werden können.

Mit Substraten sind hier hauptsächlich Siliziumscheiben (Wafer) gemeint, aus denen ein oder mehrere Siliziumhalbleiterbauelemente, wie. z.B. Dioden oder Thyristoren gefertigt werden. Es kann sich jedoch auch um Substrate aus Keramik oder anderen Werkstoffen handeln.

Eine typische Anordnung zur Durchführung eines CVD-Prozesses in der Halbleiterfertigung ist z.B. in der Zeitschrift "e", Nr. 18 vom 15. Sept. 1987, Seite 45 dargestellt. Bei der bekannten Anordnung werden beispielsweise 100 bis 150 Siliziumscheiben auf einen Träger (Waferhalterung, Waferboat) in einem Abstand zueinander horizontal aufgereiht und in einem Reaktionsgefäß angeordnet, das von außen beheizt und von einem Gasgemisch durchströmt wird.

Bei diesen Anordnungen treten aufgrund der Anzahl und der Abstände der Wafer zueinander strömungstechnische Probleme auf, was sich in ungleichmäßiger Schichtbelegung auf dem Einzel-Wafer und innerhalb einer Charge äußern kann. Dazu kommt insbesondere z.B. bei einer SI-POS-(Semi-Insulating Polysilicon)-Abscheidung die ungleichmäßige Beschichtung durch einen bevorzugten SiH4-Zerfall am Waferboat, was nur durch eine aufwendige Modifizierung der Waferhalterung verbessert werden kann. Im Ergebnis führen diese Problems zu hohen Ausschußraten und entsprechend hohen Kosten. Außerdem werden diese Probleme bei der in der Halbleiterindustrie beabsichtigten Verwendung von größeren Wafern noch gravierender. Man kann die aufgezeigten Probleme verringern durch eine sogenannte Einzelbeschichtung, bei der jeweils nur ein Wafer gleichzeitig von dem Gasgemisch angeströmt wird. Im Hinblick auf eine dabei anzustrebende Wirtschaftlichkeit ergibt sich daraus die der Erfindung zugrundeliegende Aufgabe, ein Verfahren und eine Anordnung zur Beschichtung anzugeben, das zu einer Verkürzung der für den Beschichtungsvorgang erforderlichen Zeit führt und das zu reproduzierbar guten Ergebnissen führt.

Diese Aufgabe wird bei einem Verfahren nach dem Oberbegriff des Anspruchs 1 durch dessen kennzeichnende Merkmale gelöst. Eine Anordnung zur Durchführung des Verfahrens sowie vorteilhafte Ausgestaltungen sind in den weiteren Ansprüchen angegeben.

Nach der erfindungsgemäßen Lösung wird ein Jet-Stauflußreaktor benutzt, in welchem ein einzelnes Substrat in exakt definierter Weise von einem Gasstrom mit hoher Geschwindigkeit angeströmt wird. Das benutzte Gasgemisch kann in einer vorgeschalteten besonderen Gasmischkammer hergesstellt werden oder in einer erfindungsgemäß ohnehin erforderlichen Kammer, in der das Gas gestaut wird. Von dort strömt das Gasgemisch durch eine Düse in ein Reaktionsgefäß und trifft dort auf ein entsprechend angeordnetes Substrat. Außerdem wird vorgeschlagen, den CVD-Prozeß durch einen Laserstrahl zu aktivieren. Damit wird also ein LASER-Jet-Stauflußreaktor vorgeschlagen, der eine Behandlung von erwärmten oder kalten Substraten ermöglicht. Eine Behandlungsart kann eine Beschichtung sein oder eine Materialabtragung. Die Möglichkeit der Materialabtragung erlaubt beispielsweise eine Strukturierung von Photoresist oder ein Ätzen von Gräben. Das Gasgemisch ist selbstverständlich in seiner Zusammensetzung an den jeweiligen Prozeß angepaßt.

Die erfindungsgemäße Anordnung bietet eine Reihe von weiteren Vorteilen. Die Strömungsverhältnisse im Reaktonsgefäß sind z.B. mit Hilfe eines Computerprogramms exakt erfaßbar und somit wunschgemäß einstellbar. Die geometrischen Verhältnisse wie Düsenform, Düsendurchmesser, Abstand zwischen Düse und Substrat und die Strömungsgeschwindigkeit sind genau einstellbar. Die Gasgeschwindigkeit am Substrat ist hoch. Der Nachteil einer Gasverarmung durch komplizierte Gasführung entfällt. Es bestehen mehrere Möglichkeiten durch Zusatzmaßnahmen, wie. z.B. Plasmaerzeugung und Ultraschall, eine weitere Aktivierung des Prozesses herbeizuführen oder Diagnosen durchzuführen. Außerdem läßt sich der Beschichtungsprozeß automatisieren. Die erfindungsgemäße Anordnung ist nicht nur als Fertigungseinrichtung, sondern auch für grundlegende Untersuchungen geeignet.

Weitere Einzelheiten und Vorteile werden aus den in der Zeichnung dargestellten Ausführungsbeispielen deutlich. Übereinstimmende Komponenten sind in den Figuren mit den gleichen Bezugszeichen versehen.

Es zeigen:

Fig. 1 Beschichtungsanordnung nach dem Stand der Technik,

Fig. 2 Prinzipdarstellung der erfindungsgemäßen Lösung,

Fig. 3 Anordnung zur Verbesserung des erfindungsgemäßen Prozesses durch Ultraschallanregung des Substrats,

Fig. 4 Gasmischeinrichtung,

Fig.5 Schleusenierinchtung für quasi kontinuierlichen Beschichtungsprozeß.

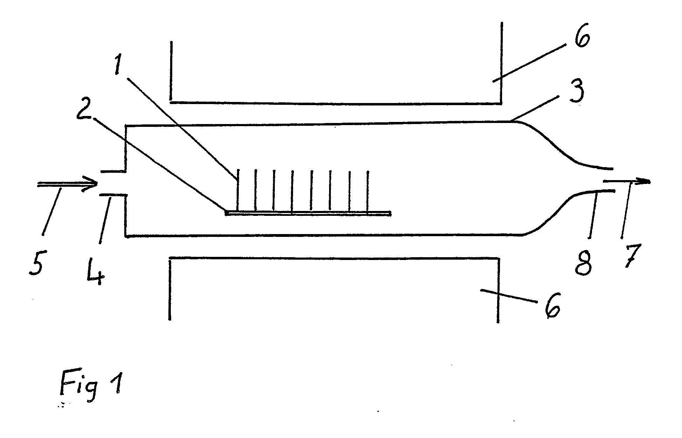

Fig. 1 zeigt eine Anordnung nach dem Stand der Technik. Dabei sind mehrere Substrate 1 auf einem Träger 2 in einem Abstand zueinander aufgereiht. Diese Anordnung befindet sich in einem Reaktionsgefäß 3, dem über eine Einlaßöffnung 4 ein Gasgemisch 5 zugeführt wird. Das Reaktionsgefäß 3 und die darin befindlichen Substrate 1 werden durch eine Heizeinrichtung 6 (Ofen) auf eine für den CVD-Prozeß erforderliche Temperatur aufgeheizt. Das durch die Abscheidung von Material an den Substratoberflächen veränderte Gas verläßt als Abgas 7 das Reaktionsgefäß 3 über eine Abgasöffnung 8. Die Nachteile dieser Anordnung sind in der Beschreibungseinleitung bereits genannt.

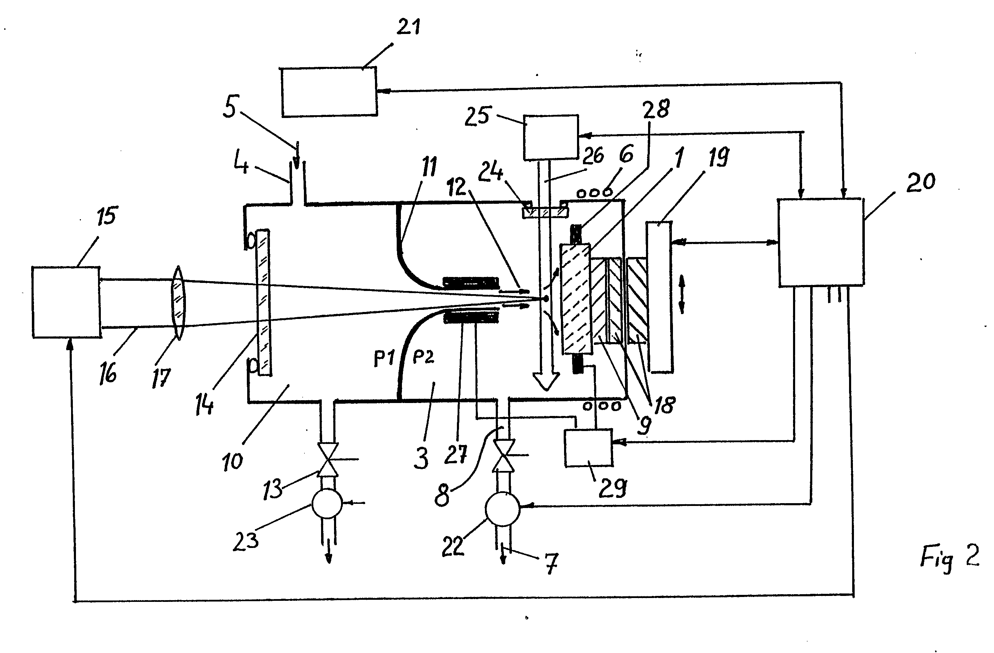

Fig. 2 zeigt eine Prinzipdarstellung der erfindungsgemäßen Lösung. Dabei ist im Reaktionsgefäß 3 ein einzelnes Substrat 1 auf einem Substrathalter 9 angeordnet. Der Substrathalter 9 kann z.B. aus Molybdän oder Graphit bestehen und wirkt - beispielsweise bei Ausführung der Heizeinrichtung 6 als Hochfrequenzheizung - als Suszeptor, der sich aufheizt und die Wärme an das Substrat 1 abgibt. Das Substrat 1 wird aus einer Kammer 10 durch eine Düse 11 von einem Gasstrom 12 (Jet) mit hoher Geschwindigkeit axialsymmetrisch angeströmt. Der Kammer 10 ist das Gasgemisch 5 über die Einlaßöffnung 4 zugeführt. Über ein Ventil 13 und eine erste Pumpeinrichtung 23 wird in der Kammer 10 ein Druck P1 eingestellt, der höher ist als ein Druck P2 im Reaktionsgefäß 3, der über eine zweite Pumpeinrichtung 22 zum Absaugen des Abgases 7 über die Abgasöffnung 8 eingestellt wird.

In der beschriebenen Einrichtung lassen sich definierte Strömungsverhältnisse erreichen, die zu reproduzierbaren Ergebnissen führen. Die Form der Düse 11, z.B.eine Laval-Düse, sowie der Abstand der Düsenöffnung zum Substrat 1 und alle übrigen geometrischen Daten lassen sich berechnen oder experimentell ermitteln.

Die Kammer 10 weist ein erstes Fenster 14 für die Einstrahlung von Laserlicht auf. Das Fenster 14 ist beispielsweise für eine Wellenlänge von 193nm transparent und ist so angeordnet, daß ein von einer ersten Laserlichtquelle 15 gepulst oder kontinuierlich abgegebener erster Laserstrahl 16, der von einer Linse 17 gebündelt wird, durch die Düse 11 hindurch auf das Substrat 1 gerichtet werden kann. Zweckmäßig kann ein Excimer-Laser verwendet werden, der auf einen Punkt unmittelbar vor dem Substrat 1 fokusiert ist und dort die Gasphase zur Photodissoziation anregt. Der Substrathalter 9 mit dem Substrat 1 ist über eine Magnetkupplung 18 mit einem xy-Tisch 19 verbunden. Der in zwei Koordinaten bewegliche xy-Tisch 19 wird von einer einen Rechner enthaltenden Steuer- und Regeleinrichtung 20 gesteuert. Mit Hilfe der Steuer- und Regeleinrichtung 20 kann der Beschichtungsprozeß automatisiert werden. Dazu sind Regelkreise, z.B. für den Gasstrom 12, den Laserstrahl 16 und die Bewegung des xy-Tischs 19 gebildet, wobei z.B. auch eine Dosiereinrichtung 21 für das zugeführte Gasgemisch 5, Pumpen 22, 23 zur Einstellung der jeweiligen Drücke und ggf. weitere Einrichtungen von der Steuer- und Regeleinrichtung 20 gesteuert werden.

Mit der in Fig. 2 dargestellten Anordnung kann beispielsweise der Laserstrahl 16 auf den Rand des Substrats 1 justiert werden und bei Drehung des Substrats 1 eine gezielte Randbeschichtung, z.B. Passivierung von pn-Übergängen hergestellt werden.

Soll das Substrat 1 oder das Gas vor dem Substrat 1 zusätzlich oder allein erwärmt werden, hat man die Möglichkeit, zusätzlich mit z.B. einem $CO_2$-Laser aus einer zweiten Laserlichtquelle 25 einen zweiten Laserstrahl 26 über ein zweites Fenster 24 einzustrahlen. Das heißt, man hat die Möglichkeit der Photodissoziation und der Pyrolyse im Gas und auf dem Substrat. Bei Einstrahlung eines He/Ne-Lasers ist zusätzlich die Möglichkeit von insitu-Gas-(Spektroskopie) und Oberflächenanalytik (Mikroskopie zur Beurteilung der Schichtdicke) gegeben. Fig. 2 enthält noch eine Ausgestaltung zur Durchführung eines plasmaunterstützten CVD-Prozesses. Solche Prozesse haben den Vorteil höherer Wachstums- und Nukleationsraten bei tiefen Temperaturen. Vor allem beim Abscheiden von B1-Supraleitern its es erforderlich hohe Keimbildungsraten zu haben, um ein feines Kornwachstum zu erreichen. Einzelheiten zu diesem Prozeß sind dem Aufsatz von G. Wahl, F. Schmaderer "Ceramics, today and tomorrow", Eds. S. Naka, N. Soga and S. Kume, The Ceramic Society of Japan, Tokio 1986 zu entnehmen. Um diese Plasmaunterstützung zu ermöglichen, wird gemäß Fig. 2 vorgeschlagen, auf die Düse 11 eine Hohlkathode 27 aufzuschieben und das Substrat 1 mit einer Ringanode 28 zu versehen - die von einem Zündgerät 29 mit Hochfrequenzenergie, z.B. 13,56 MHz und 200 W versorgt werden - und eine Entladung zwischen Kathode 27 und Anode herbeizuführen. Zusätzlich kann Laserlicht z.B. durch die Düse 11 eingestrahlt werden, um eine Plasma-Diagnostik zu ermöglichen.

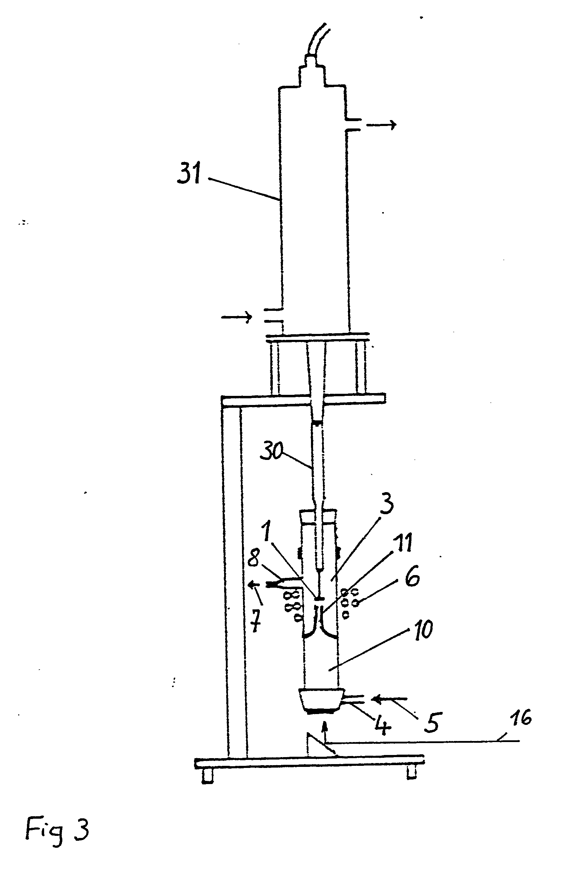

· Die erfindungsgemäße LASER-Stauflußanordnung läßt sich auch sehr gut in Verbindung mit einem aus T. Takahashi, H. Iron, J. of Crystal Growth 49 (1980), Seite 445 bis 450 bekannten Verfahren anwenden, bei dem mit Hilfe von Ultraschall eine Veränderung des Kornwachstums herbeigeführt wird. Um diese Ausgestaltung zu verdeutlichen, ist in Fig. 3 die dazu erforderliche Modifikation einer aus der genannten Veröffentlichung bekannten Anordnung angegeben. Dabei ist das Substrat 1 über ein Horn 30 an eine Ultraschallquelle 31 angekoppelt. Das Substrat 1 wird aus der Düse 11 mit dem Gasgemisch 5 angeströmt.

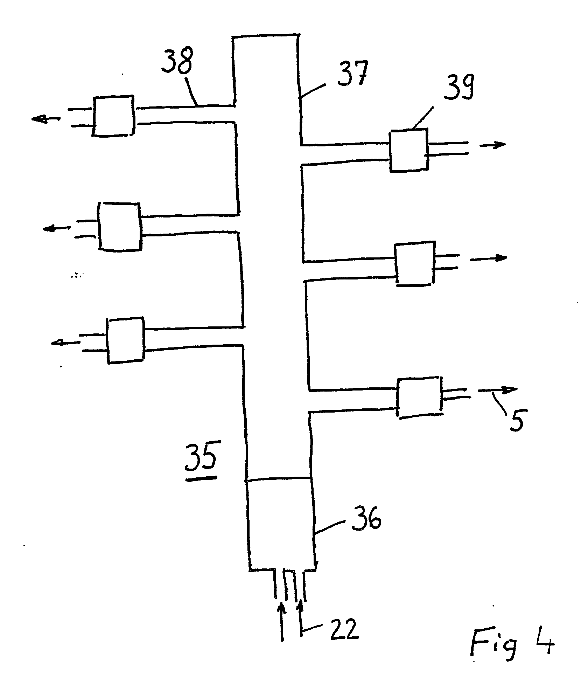

Um eine größere und quasi kontinuierlich arbeitende Produktionsanlage zu schaffen, können mehrere der in den Fig. 2 und 3 dargestellten Anordnungen aus einer in Fig. 4 dargestellten zentralen Gasversorgungseinrichtung 35 gespeist werden. Dazu können in einer solchen Gasversorgungseinrichtung 35 alle Gase in einer Mischkammer 36 in der richtigen Zusammensetzung gemischt werden und z.B. über eine Steigleitung 37 mit sternförmigen Abzweigen 38 in mehreren Etagen den einzelnen Kammern 10 vor den Reaktionsgefäßen 3 zugeführt werden. Eine gleichmäßige Verteilung der Reaktionsgase an die Rezipienten, d.h. Kammern 10, kann über unterschiedliche Querschnitte der Gaszuführungen oder über eine Gasstrommessung und Dosiereinrichtungen 39 erreicht werden.

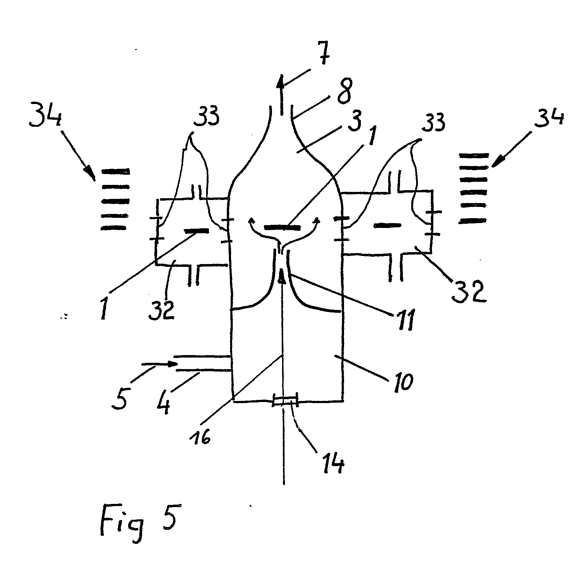

In Fig. 5 ist schematisch dargestellt, wie für einen quasi kontinuierlichen Betrieb die Reaktionsgefäße 3 durch eine Anordnung von Schleusenkammern 32 mit Schleusen 33 für die Zu- und Abfuhr von Substraten 1 aus und zu Magazinen 34 ergänzt werden können. Die Steuerung der Schleusen und eine dazu koordinierte Steuerung von Einrichtungen zur Be- und Entlüftung der Schleusenkammern 32 und ein kontinuierlicher Austausch der Substrate 1 kann computergesteuert erfolgen.

**Ansprüche**

1. Verfahren zur Oberflächenbehandlung von Komponenten für die Herstellung von Halbleiterbauelementen oder von sonstigen Substraten, insbesondere zur Beschichtung durch Abscheidung eines Materials aus der Gasphase (CVD-Prozeß), wobei eine Gasmischung an eine zu behandelnde Fläche eines Substrats herangeführt wird, dadurch gekennzeichnet, daß das Gasgemisch in einem Stauraum auf einen ersten Gasdruck (P1) gebracht wird, mit Hilfe einer Düse das Gasgemisch als Gasstrom mit hoher Geschwindigkeit (Jet) auf das Substrat geleitet wird, das sich in einem Reaktionsgefäß befindet, in welchem ein zweiter Gasdruck (P2) herrscht, der niedriger ist als der erste Gasdruck (P1) und daß der CVD-Prozeß durch einen Laserstrahl aktiviert wird.

2. Verfahren nach Anspruch 1, dadurch gekennzeichnet, daß als Oberflächenbehandlung eine Abtragung eines Materials von der Substratoberfläche, z.B. zur Oberflächenstrukturierung, mit Hife eines Reaktionsgases erfolgt.

3. Verfahren nach Anspruch 1 oder 2, dadurch gekennzeichnet, daß das Substrat auf eine für den CVD-Prozeß geeignete Temperatur gebracht wird.

4. Verfahren nach Anspruch 1 oder 2, dadurch gekennzeichnet, daß die Beschichtung oder Strukturierung an einem etwa auf Raumtemperatur befindlichen Substrat erfolgt.

5. Anordnung zur Durchführung des Verfahrens nach einen der Ansprüche 1 bis 4, bestehend aus
- mindestens einem Reaktionsgefäß, in dem mindestens ein Substrat angeordnet ist,
- mit einer Einlaßöffnung am Reaktionsgefäß für die Zufuhr eines Gasgemisches und einer Auslaßöffnung für Abgas und, soweit für den jeweiligen Prozeß erforderlich,
- einer Heizeinrichtung zur Erwärmung des Substrats,
dadurch gekennzeichnet, daß
- die Einlaßöffnung am Reaktionsgefäß (3) als Düse (11) ausgeführt ist,
-. vor der Einlaßöffnung als Stauraum eine Kammer (10) angeordnet ist, der das Gasgemisch (5) zugeführt ist,
- das Substrat (1) in einem durch Berechnung oder experimentell als geeignet ermittelten Abstand vom Ausgang der Düse (11) angeordnet und von einem Gasstrom (12) aus der Düse (11) angeströmt ist, und
- in der Kammer (10) gegenüber der Düse (11) ein erstes Fenster (14) angeordnet ist, durch das ein gepulster oder kontinuierlicher Laserstrahl (16) auf das Substrat (1) gerichtet und auf einen Punkt kurz vor dem Substrat (1) fokusiert ist.

6. Anordnung nach Anspruch 5, dadurch gekennzeichnet, daß in der Kammer (10) oder im Reaktionsgefäß (3) ein zweites Fenster (24) vorgesehen ist, zur Einstrahlung eines zweiten Laserstrahls (26), z.B. um eine Pyrolyse oder Fotolyse des Gases oder eine in-situ-Gas-Spektroskospie oder eine Substrat-Oberflächenanalyse, z.B. hinsichtlich der Dicke einer abgeschiedenen Schicht zu ermöglichen.

7. Anordnung nach Anspruch 5 oder 6, dadurch gekennzeichnet, daß zur Durchführung eines plasmaunterstützen CVD-Prozesses über der Düse (11) eine Hohlkathode (27) und um das Substrat (1) eine Ringanode (28) angeordnet sind, an die eine Hochfrequenzspannung angelegt ist.

8. Anordnung nach einem der Ansprüche 5 bis 7, dadurch gekennzeichnet, daß das Substrat (1) auf einem mindestens in zwei Ebenen beweglichen Substrathalter (9) angeordnet ist, wobei der Substrathalter (9) in seiner Position durch einen Regelkreis gesteuert ist.

9. Anordnung nach Anspruch 8, dadurch gekennzeichnet, daß die Position des Substrathalters (9) über eine Magnetkupplung (8) an die Position eines xy-Tischs (19) gekoppelt ist.

10. Anordnung nach einem der Ansprüche 5 bis 7, dadurch gekennzeichnet, daß zur Beeinflussung des Kornwachstums auf dem Substrat (1) das Substrat (1) an eine Ultraschallquelle (31) angekoppelt ist.

11. Anordnung nach einem der Ansprüche 5 bis 10, dadurch gekennzeichnet, daß zusätzlich eine zentrale Gasversorgungseinrichtung (35) vorgesehen ist, in der in einer Mischkammer (36) mehrere Gase gemischt werden, ehe sie mindestens einer oder parallel mehreren Kammern (10) zugeführt werden.

12. Anordnung nach einem der Ansprüche 5 bis 11, dadurch gekannzeichnet, daß ein oder mehrere Reaktionsgefäße (3) mit Schleusenkammern (32) und Schleusen (33) für einen kontinuierlichen Austausch von Substraten vorgesehen sind.

13. Anordnung nach einem der Ansprüche 5 bis 12, dadurch gekennzeichnet, daß die Quelle (15, 25) für den Laserstrahl (16, 26) ausgewählt ist aus Excimerlaser oder Spektrallampen (Excimer-Strahler), die im UV-Bereich arbeiten oder $Ar^+$- oder $Kr^+$-Laser im sichtbaren Bereich, oder $CO_2$ oder Nd-Yag-Laser im IR-Bereich.

Fig 1

Fig 2

EP 0 320 724 A2

Fig 3

Fig 4

Fig 5